# EUROPÄISCHE PATENTSCHRIFT

(11) **EP 2 394 363 B1**
(45) Veröffentlichungstag und Bekanntmachung des Hinweises auf die Patenterteilung: **06.07.2016**
(21) Anmeldenummer: 10702586.8
(22) Anmeldetag: 03.02.2010
(51) Int. Cl.: H03K 17/0814, H03K 17/10, H03K 17/687

(54) **JFET-SERIESCHALTUNG**
JFET SERIES CONNECTION
MONTAGE SÉRIE DE TRANSISTORS JFET

(30) Priorität: 05.02.2009 CH 160092009
(43) Veröffentlichungstag der Anmeldung: 14.12.2011
(73) Patentinhaber: ETH Zurich, 8092 Zürich (CH)
(72) Erfinder: BIELA, Jürgen, CH-8004 Zürich (CH); KOLAR, Johann, W., CH-8044 Zürich (CH); AGGELER, Daniel, CH-8044 Zürich (CH)
(74) Vertreter: Frei Patent Attorneys
(86) Internationale Anmeldenummer: PCT/CH2010/000028
(87) Internationale Veröffentlichungsnummer: WO 2010/088783

(56) Entgegenhaltungen:
- DE-A1- 19 926 109
- AGGELER D ET AL: "A compact, high voltage 25 kW, 50 kHz DC-DC converter based on SiC JFETs" APPLIED POWER ELECTRONICS CONFERENCE AND EXPOSITION, 2008. APEC 2008. TWENTY-THIRD ANNUAL IEEE, IEEE, PISCATAWAY, NJ, USA, 24. Februar 2008 (2008-02-24), Seiten 801-807, XP031253339 ISBN: 978-1-4244-1873-2

## Beschreibung

Die Erfindung bezieht sich auf das Gebiet der elektronischen Schaltungstechnik und insbesondere auf eine Schalteinrichtung mit einer Serieschaltung von Sperrschicht-FETs (JFET oder Junction Field Effect Transistor) gemäss dem Oberbegriff von Patentanspruch 1.

### STAND DER TECHNIK

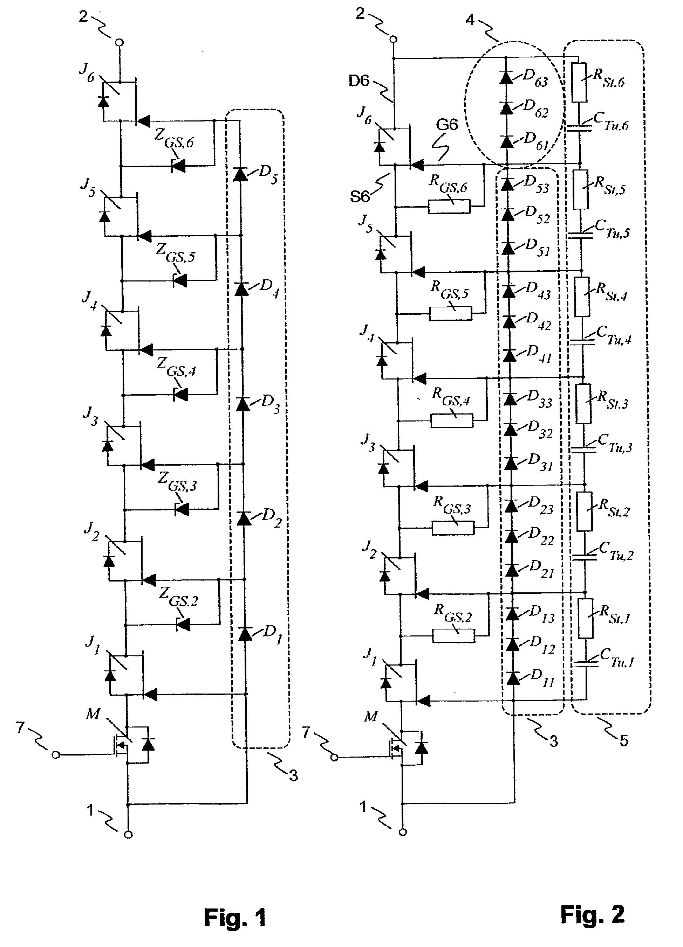

Leistungsschalter oder Schalteinrichtungen zum Schalten bei hohen Betriebsspannungen können in leistungselektronischen Schaltungen durch Kaskadierung oder in Serie angeordnete Transistoren realisiert werden. Dabei werden nach US 6,822,842 oder DE 199 26 109 A1, welche eine Schaltung gemäss dem Oberbegriff von Anspruch 1 offenbart, solche Schalteinrichtungen beispielsweise als Kaskode-Schaltung bezeichnet, welche auf der speziellen Zusammenschaltung eines MOSFET M und mindestens einem JFET J₁ basieren, illustriert durch die **Figur 1**. Die Schalter sind zwischen einem ersten Anschluss 1 und einem zweiten Anschluss 2 angeordnet und durch einen Steueranschluss 7 des MOSFET M gesteuert. Diese bekannte Schalteinrichtung für hohe Betriebsspannungen basierend auf der Kaskoden-Topologie sieht vor, mehrere JFETs J₂ ... Jᵢ in Serie zu schalten und damit eine hohe Sperrspannung zu erreichen. Zum Schutz der JFETs werden Dioden, d.h. im Sperrbetrieb eingesetzte Schutzdioden D₁-D₅ an die Gate-Anschlüsse der JFETs angeschlossen. Diese Schutzdioden verbinden die Gate-Anschlüsse der JFETs untereinander, oder führen jeweils von den Gate-Anschlüssen zu einem gemeinsamen Anschluss 1 auf einem Grundpotential, an welchem auch der MOSFET angeschlossen ist. Die Funktionsweise der Schutzdioden D₁-D₅ zum Schutz der JFETs ist in US 6,822,842 beschrieben.

Aufgrund unterschiedlicher oder zu grosser Sperrschichtkapazitäten der Schutzdioden D₁-D₅ kann eine ungleichmässige Aufteilung der Sperrspannung über den JFETs entstehen. Dabei wirkt speziell beim obersten JFET J₆ der Fig. 1, eine andere Kapazität im Gate-Anschluss als bei den unteren JFETs. Diese unterschiedliche Belastung der Gate-Anschlüsse kann die dynamische Aufteilung der Sperrspannung stark beeinflussen und dazu führen, dass zuerst der oberste Transistor die gesamte Spannung zwischen den Anschlüssen aufnimmt und im schlimmsten Fall zerstört wird.

### DARSTELLUNG DER ERFINDUNG

Es ist deshalb Aufgabe der Erfindung, eine Schalteinrichtung mit einer Serieschaltung von Sperrschicht-FETs der eingangs genannten Art zu schaffen, welche die oben genannten Nachteile behebt.

Diese Aufgabe löst eine Schalteinrichtung mit einer Serieschaltung von Sperrschicht-FETs mit den Merkmalen des Patentanspruches 1.

Die Schalteinrichtung zum Schalten eines Stromes zwischen einem ersten Anschluss und einem zweiten Anschluss, weist also eine Serieschaltung von mindestens zwei JFETs auf, von denen ein unterster JFET mit dem ersten Anschluss verbunden ist oder über einen in Serie angeordneten Steuerschalter mit dem ersten Anschluss verbunden ist. Es liegt mindestens ein weiterer JFET vor, der zu dem untersten JFET in Serie geschaltet ist, wobei der am weitesten vom untersten JFET entfernte JFET als oberster JFET bezeichnet wird und mit seinem Drainanschluss mit dem zweiten Anschluss verbunden ist. Es ist eine Stabilisierungsschaltung zur Stabilisierung der Gatespannungen der JFETs, zwischen die Gateanschlüsse der JFETs und dem ersten Anschluss geschaltet. Dabei ist zwischen dem Gateanschluss des obersten JFET und dem zweiten Anschluss eine Zusatzschaltung geschaltet welche das Potential am Gateanschluss des obersten JFET zum Potential am Drainanschluss des obersten JFET hin zieht und die Spannung verkleinert.

Dadurch wird beim eingeschalteten obersten JFET die Spannung am Gate gering über, vorzugsweise aber gleich der Spannung am Sourceanschluss gehalten, wodurch beim Ausschalten der oberste JFET länger eingeschaltet bleibt als ohne die Zusatzschaltung. Dadurch wiederum wird verhindert, dass die gesamte Spannung zwischen dem ersten und dem zweiten Anschluss am obersten JFET anliegt.

Das Netzwerk mit Stabilisierungsschaltung und Zusatzschaltung bewirkt, dass weiter oben angeordnete JFETs beim Ausschalten langsamer ausgeschaltet und schneller eingeschaltet werden, vorzugsweise synchrone Einschaltzeitpunkte aufweisen, als weiter unten angeordnete JFETs.

Dadurch wird die dynamische Sperrspannungsaufteilung des mit seriell angeordneten Transistoren aufgebauten Leistungsschalters, durch das gesamte Beschaltungsnetzwerk aus Stabilisierungsschaltung und Zusatzschaltung, sowohl balanciert als auch stabilisiert.

Die Stabilisierungsschaltung für sich alleine gesehen vermag, allgemein gesprochen, für jeden der JFETs einen vorgebbaren Strom zwischen dessen Gateanschluss und dem ersten Anschluss abzuleiten. Die Zusatzschaltung zusammen mit der Stabilisierungsschaltung bewirkt eine symmetrische Spannungsbelastung der Gateanschlüsse der seriell geschalteten JFETs.

Die Serieschaltung der JFETs kann mit einer Ansteuerung des untersten JFET in einer Kaskodeschaltung realisiert werden. Dabei weist die Serieschaltung einen Steuerschalter auf, beispielsweise einen MOSFET, der zwischen dem ersten Anschluss und einem untersten JFET geschaltet ist. Alternativ können die JFETs auch anders angesteuert werden, beispielsweise der unterste JFET mit einer direkten Ansteuerung seines Gate-Anschlusses durch eine Treiberschaltung.

Das Zeitverhalten der passiven Ansteuerung des obersten JFET ist, wenn es durch eine oder mehrere weitere Dioden realisiert ist, durch Wahl der gesamten Sperrschichtkapazität der Serieschaltung dieser weiteren Dioden einstellbar. Die Sperrschichtkapazität ist durch die Anzahl der seriellen weiteren Dioden und/oder durch die Auslegung der einzelnen weiteren Dioden einstellbar. Die Gesamt-Sperrspannung oder Durchbruchspannung einer oder mehrerer Dioden zwischen Drain und Gate des obersten JFET wird mindestens annähend gleich wie bei den übrigen JFETs gewählt.

In einer weiteren bevorzugten Ausführungsform der Erfindung wird die Sperrschichtkapazität der weiteren Dioden klein gehalten und stattdessen eine Kapazität zwischen dem zweiten Anschluss und dem Gate des obersten JFET (und auch den weiteren JFETs) durch separate Elemente wie Kondensatoren eingestellt. Durch ein so gebildetes zusätzliches Symmetriernetzwerk ist das schnelle Schaltverhalten optimierbar. Das Symmetriernetzwerk weist also ein zwischen den Gates der JFETs und dem ersten Anschluss angeordnetes RC-Netzwerk auf. Beispielsweise sind die Gates von jeweils aufeinanderfolgenden JFETs durch jeweils eine Serieschaltung eines Widerstandes mit einer weiteren Kapazität verbunden, und ist das Gate des obersten JFETs durch ein vorzugsweise gleich strukturiertes Zusatz-RC-Glied mit dem zweiten Anschluss verbunden.

In einer anderen bevorzugten Ausführungsform der Erfindung sind die Gates der JFETs ausser des untersten JFETs durch jeweils eine Serieschaltung eines Widerstandes mit einer Kapazität mit dem ersten Anschluss verbunden, und ist zusätzlich das Gate des obersten JFETs durch eine Zusatzschaltung, vorzugsweise ein Zusatz-RC-Glied aus einer Serieschaltung eines Widerstandes mit einer weiteren Kapazität mit dem zweiten Anschluss verbunden.

In einer weiteren bevorzugten Ausführungsform der Erfindung sind die Gates der JFETs ausser des untersten JFETs durch jeweils eine Serieschaltung eines Widerstandes mit einer Kapazität mit dem ersten Anschluss verbunden, und sind zusätzlich die Gates der JFETs durch eine oder mehrere Dioden mit dem zweiten Anschluss verbunden. Das Gate des obersten JFETs ist zusätzlich durch eine Zusatzschaltung, vorzugsweise ein Zusatz-RC-Glied aus einer Serieschaltung eines Widerstandes mit einer weiteren Kapazität mit dem zweiten Anschluss verbunden.

In weiteren bevorzugten Ausführungsformen der Erfindung liegt nicht bei jeder der Kapazitäten (respektive der weiteren Kapazität) ein Widerstand zur Dämpfung vor, sondern nur bei einem oder mehreren, vorzugsweise bei weiter oben liegenden JFETs.

Grundsätzlich ist im Symmetriemetzwerk auch eine Parallelschaltung von Widerständen mit Kapazitäten möglich, jedoch sind damit statische Verluste infolge des auftretenden statischen Spannungsteilers in die Topologie eingeprägt.

Das Symmetriernetzwerk ist vorzugsweise so ausgelegt, dass bei einem Schaltvorgang auftretende Ausgleichsvorgänge im Symmetriernetzwerk am obersten JFET die kleinste und am untersten JFET die grösste Zeitkonstante aufweisen. Dem entsprechend ist die Kapazität des Zusatz-RC-Gliedes (oder eines Zusatz-C-Gliedes) kleiner als die Kapazität des untersten, am Gate des untersten JFETs angeschlossenen RC-Gliedes (oder C-Gliedes). Vorzugsweise nimmt die Kapazität der dazwischen liegenden RC-Glieder oder C-Glieder von oben nach unten sukzessive zu. Durch das Zusammenwirken des Symmetriernetzwerkes mit der Stabilisierungsschaltung weisen die Ausgleichsvorgänge an den Gates der JFETs ausgeglichene Zeitkonstanten auf.

Dies bewirkt, dass es - im Vergleich zu der Schaltung ohne das Symmetriemetzwerk - beim Ausschalten der Transistoren respektive JFETs bei weiter oben liegenden JFETs länger dauert, bis der jeweilige Gateanschluss das Potential der Pinch-Off Spannung im Bezug auf den jeweiligen Sourceanschlusses erreicht. Dadurch bleiben die oberen JFETs länger als die unteren JFETs eingeschaltet und dementsprechend werden die oberen JFETs langsamer ausgeschaltet. Umgekehrt werden die oberen JFETs beim Einschalten schneller eingeschaltet als ohne die Zusatzschaltung und das Symmetriemetzwerk. Idealerweise erreicht man ein komplett synchrones Ein- und Ausschalten aller JFETs.

Durch die Auslegung des Symmetriernetzwerkes sind die zeitlichen Verläufe bei den Vorgängen an den einzelnen Schaltern aufeinander abgestimmt, so dass die Schaltanordnung als Ganzes ein möglichst optimal ausgeglichenes Verhalten aufweist, also ein möglichst zeitgleiches Schalten der einzelnen JFETs.

In einer weiteren Ausführungsform der Erfindung wird der Steuerschalter, beispielsweise ein MOSFET, im linearen Bereich betrieben. Dadurch wird eine Dämpfung von Oszillationen, die durch Sperrschichtkapazitäten erzeugt werden, erreicht.

Die Stabilisierungsschaltung bildet also zusammen mit der Zusatzschaltung und dem Symmetriernetzwerk einen dynamischen Spannungsteiler zwischen der Spannung am ersten und am zweiten Anschluss, welcher bei Schaltvorgängen die Spannungsbelastung der JFETs vergleichmässigt. Anders als bei den bekannten Leistungsschaltern oder Schalteinrichtungen zum Schalten hoher Betriebsspannungen wird die Balancierung der dynamischen Sperrspannungsbelastung der Transistoren durch Hinzufügen der Zusatzschaltung, beispielsweise durch die zusätzlichen Dioden signifikant verbessert, und kann zudem in einer bevorzugten Ausführungsform der Erfindung gezielt durch eine RC-Beschaltung optimiert werden.

Weitere bevorzugte Ausführungsformen gehen aus den abhängigen Patentansprüchen hervor.

### KURZE BESCHREIBUNG DER ZEICHNUNGEN

Im Folgenden wird der Erfindungsgegenstand anhand von bevorzugten Ausführungsbeispielen, welche in den beiliegenden Zeichnungen dargestellt sind, näher erläutert. Es zeigen jeweils schematisch:
- Figur 1: eine Serieschaltung von Sperrschicht-FETs gemäss dem Stand der Technik;
- Figur 2: eine erste Ausführungsform der Erfindung;
- Figur 3: eine zweite Ausführungsform der Erfindung, und
- Figur 4: eine weitere Ausführungsform der Erfindung.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### WEGE ZUR AUSFÜHRUNG DER ERFINDUNG

In Fig. 1 ist die Erfindung für eine Schalteinrichtung hoher Betriebsspannung dargestellt. Die Schaltung weist eine Kaskodeschaltung eines MOSFET M mit einem ersten oder untersten JFET J₁ und mindestens einem in Serie zu diesem ersten JFET J₁ geschalteten weiteren JFET J₂-J₆ auf. Der unterste oder erste JFET ist also in der Kaskodeschaltung von einem als Steuerschalter wirkenden MOSFET angesteuert. Der letzte, am weitesten vom ersten JFET entfernte JFET der in Serie geschalteten JFETs wird auch als oberster JFET J₆ bezeichnet. Es sind lediglich beispielhaft sechs JFETs gezeigt, es können allgemein, in anderen Ausführungsformen der Erfindung, zwei oder mehr JFETs vorliegen. Zur Stabilisierung der Gatespannungen der JFETs ist eine Stabilisierungsschaltung 3 angeordnet. Diese weist jeweils zwischen den Gates zweier aufeinanderfolgender JFETs eine Serieschaltung von in Sperrichtung betriebenen Schutzdioden D₁₁-D₁₃, D₂₁-D₂₃, ... D₅₁-D₅₃ auf. Die Anzahl von Schutzdioden D₁₁-D₅₃ die jeweils zueinander in Serie liegen hängt von der erforderlichen Sperrspannung der Schutzdioden D₁₁-D₅₃ ab. Allgemein können jeweils eine oder mehrere Schutzdioden D₁₁-D₅₃ zwischen den Gates zweier aufeinanderfolgender JFETs vorliegen. In anderen Ausführungsformen der Erfindung sind andere Schaltelemente als Dioden verwendet.

Jeweils zwischen Gate und Source der JFETs J₂-J₆ ausser dem ersten JFET sind Zenerdioden (in Figur 1: Z_{GS,2}-Z_{GS,6}) oder Widerstände (in Figur 2: Z_{GS,2}-Z_{GS,6}) geschaltet. Diese stabilisieren die jeweilige Gatespannung im stationären Zustand.

Zur Vergleichmässigung der Spannungsbelastung der JFETs ist zwischen dem Gate und dem Drainanschluss des obersten JFETs eine Zusatzschaltung 4 geschaltet. Diese weist gemäss der Figur 2 eine Serieschaltung aus drei von in Sperrichtung betriebenen weiteren Dioden D₆₁, D₆₂, D₆₃ auf. Diese bewirken, dass das Potential am Gateanschluss des obersten JFET zum Potential am Drainanschluss des obersten JFET hin gezogen wird und damit die anliegende zwischen dem Drainanschluss und dem Gateanschluss verkleinert wird. Die weiteren Dioden D₆₁, D₆₂, D₆₃ gewährleisten eine symmetrische Belastung der Gate-Anschlüsse und stabilisieren die Sperrspannungsaufteilung. Zusätzlich wirken sie als Schutzelement für den obersten JFET J₆ gegen Überspannung zwischen Drain und Gate.

Anstelle der weiteren Dioden können in der Zusatzschaltung andere Schaltungselemente vorliegen, welche den gleichen Effekt bewirken, z.B. nur eine oder zwei oder mehr in Serie geschaltete weitere Dioden, ein Widerstand, eine Kapazität oder eine RC-Schaltung.

In einer bevorzugten Ausführungsform der Erfindung ist jeweils zwischen den Gates zweier aufeinanderfolgender JFETs, parallel zu den jeweils einen oder mehrere Schutzdioden D₁₁-D₅₃, ein RC-Glied aus einer Serieschaltung eines Widerstandes oder Dämpfungswiderständes R_{St,1}-R_{St,5} mit einer Kapazität C_{Tu,1}-C_{Tu,5} geschaltet. In diesem Fall ist auch zwischen dem Gate und dem Drainanschluss des obersten JFETs ein analoges, vorzugsweise gleich strukturiertes RC-Glied parallel zu der Zusatzschaltung 4 geschaltet. Alle diese genannten RC-Glieder bilden zusammen ein Symmetriernetzwerk 5.

Das gesamte Beschaltungsnetzwerk weist dann also zusätzliche 1 bis n Dioden D₆₁, D₆₂, D₆₃, und das passive R-C Netzwerk mit Dämpfungswiderständen R_{St,1} ... R_{St,6} und Kapazitäten C_{Tu,1} ... C_{Tu,6}.

Durch die Serieschaltung der Dioden kann die totale Sperrschichtkapazität, welche zwischen den Gate-Anschlüssen jeweils hinzugefügt wird, klein gehalten werden. Das ergibt die Möglichkeit, dank den zusätzlichen Kapazitäten C_{Tu,1} ... C_{Tu,6} die dynamische Sperrspannungsaufteilung zu optimieren bzw. unabhängig von den Sperrschichtkapazitäten einzustellen. Dabei werden die zusätzlichen Dämpfungswiderstände R_{St,1} ... R_{St,6} hinzugefügt, um durch die zusätzlichen Kapazitäten C_{Tu,1} ... C_{Tu,6} hervorgerufene Schwingungen zu dämpfen.

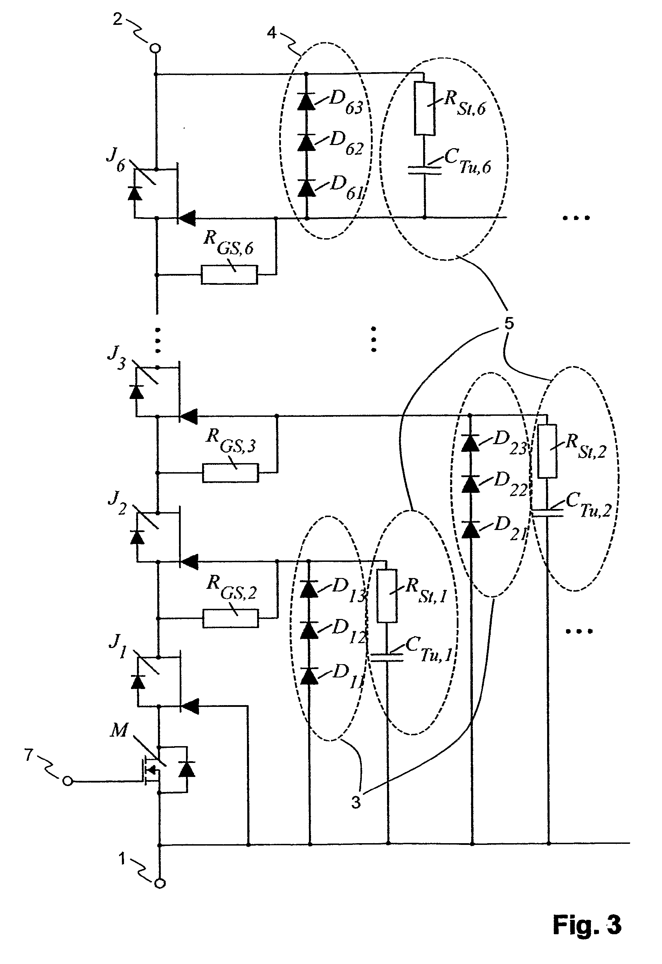

**Figur 3** zeigt eine alternative bevorzugte Ausführungsform der Erfindung, in welcher die Gates der JFETs J₁-J₆ nicht untereinander verbunden sind, sondern jeweils separat mit einer eigenen Beschaltung aus Schutzdioden D₁₁-D₅₃ und RC-Glied mit dem ersten Anschluss 1 verbunden sind. Wie in der **Figur 2** ist der Gateanschluss G₆ des obersten JFET J₆ über das Zusatznetzwerk 4 mit dem zweiten Anschluss 2 verbunden. Das Zusatznetzwerk 4 kann auch hier nur eine oder mehrere seriell geschaltete weitere Dioden D₆₁-D₆₃ aufweisen, oder andere Schaltelemente, oder die weiteren Dioden D₆₁-D₆₃ kombiniert mit einem RC-Serieglied R_{St,6}, C_{Tu,6}. Die an sich optionalen und vorzugsweise zur Optimierung eingesetzten RC-Glieder R_{St,1} ... R_{St,6} und C_{Tu,1} ... C_{Tu,6} bilden auch hier zusammen das Symmetriernetzwerk 5.

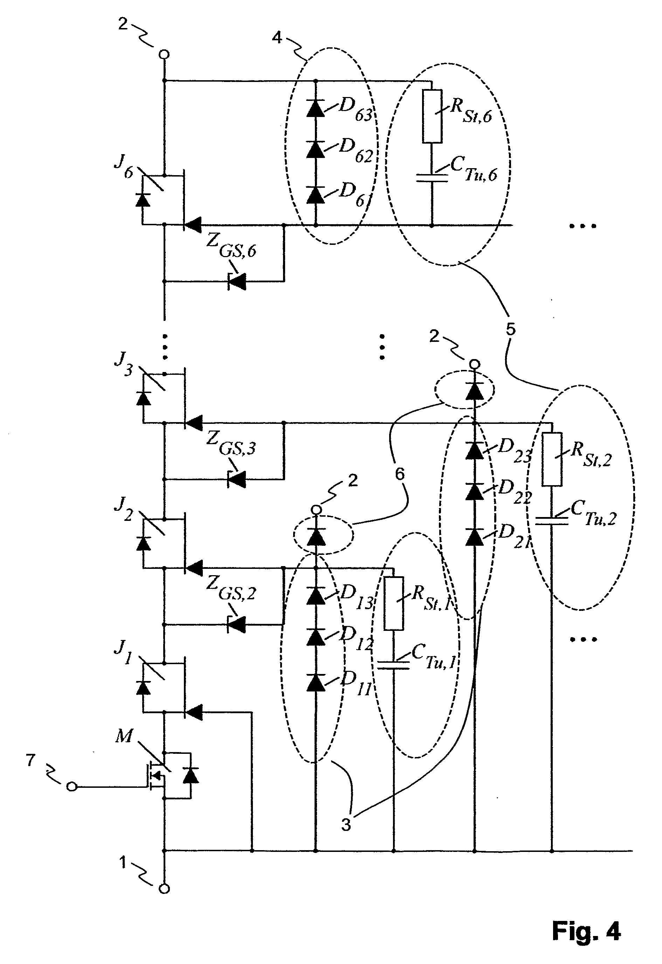

**Figur 4** zeigt eine weitere Ausführungsform der Erfindung in welcher die Gates der JFETs J₁ - J₆ nicht untereinander verbunden sind, sondern jeweils separat mit einer eigenen Beschaltung aus Schutzdioden D₁₁-D₂₃, einer oder mehreren Zusatzdioden 6, welche vom jeweiligen Gateanschluss zum zweiten Anschluss verbunden ist und über ein RC-Glied mit dem ersten Anschluss 1 verbunden sind. Die Schutzdioden D₁₁-D₂₃ und Zusatzdioden 6 bilden jeweils einen Spannungsteiler für die Gatespannung, der bezüglich Spannungsniveau und dynamischem Verhalten (Zeitkonstanten) individuell parametrisierbar ist. Anstelle der in der Figur gezeigten einzelnen Zusatzdioden 6 können auch mehrere in Serie geschaltete Dioden vorliegen. Auch das, wie in der Figur 3 angeordnete, Zusatznetzwerk 4 kann eine oder mehrere seriell geschaltete weitere Dioden D₆₁-D₆₃ aufweisen, oder andere Schaltelemente, oder die weiteren Dioden D₆₁-D₆₃ kombiniert mit einem RC-Serieglied R_{St,6}, C_{Tu,6}. Die an sich optionalen und vorzugsweise zur Optimierung eingesetzten RC-Glieder R_{St,1} ... R_{St,6} und C_{Tu,1} ... C_{Tu,6} bilden auch hier zusammen das Symmetriernetzwerk 5.

Für alle Beispiele und für die Erfindung als Ganzes gilt grundsätzlich, dass die Schaltung, sinngemäss modifiziert auch für p-Kanal JFETs anstelle der hier gezeichneten n-Kanal JFETs einsetzbar ist.

## Patentansprüche

1. Schalteinrichtung zum Schalten eines Stromes zwischen einem ersten Anschluss (1) und einem zweiten Anschluss (2), aufweisend eine Serieschaltung von mindestens zwei JFET's (J₁-J₆),
von denen ein unterster JFET (J₁) mit dem ersten Anschluss (1) verbunden ist oder der unterste JFET (J₁) in einer Kaskodeschaltung über einen Steuerschalter (M) mit dem ersten Anschluss (1) verbunden ist,
und mindestens einen weiteren JFET (J₂-J₆), der zu dem untersten JFET (J₁) in Serie geschaltet ist, wobei der am weitesten vom untersten JFET (J₁) entfernte JFET (J₆) als oberster JFET (J₆) bezeichnet wird und mit seinem Drainanschluss mit dem zweiten Anschluss (2) verbunden ist, und
wobei eine Stabilisierungsschaltung (D₁₁-D₅₃) zur Stabilisierung der Gatespannungen der JFETs (J₁-J₆), zwischen die Gateanschlüsse der JFETs (J₁-J₆) und dem ersten Anschluss (1) geschaltet ist,
wobei zwischen dem Gateanschluss (G₆)
des obersten JFET (J₆) und dem zweiten Anschluss (2) eine Zusatzschaltung (4) geschaltet ist welche das Potential am Gateanschluss (G₆) des obersten JFET (J₆) zum Potential am Drainanschluss (D₆) des obersten JFET (J₆) zieht,
**dadurch gekennzeichnet, dass** ein Symmetriernetzwerk (5) aus einem zwischen den Gates der JFETS (J₁-J₆) und dem ersten Anschluss angeordneten RC-Netzwerk vorliegt, und
wobei das Symmetriernetzwerk (5) so ausgelegt ist, dass bei einem Schaltvorgang auftretende Ausgleichsvorgänge im Symmetriernetzwerk am obersten JFET (J₆) die kleinste und am untersten JFET (J₁) die grösste Zeitkonstante aufweisen.

2. Schalteinrichtung gemäss Anspruch 1, wobei die Stabilisierungsschaltung (3) von den Gateanschlüssen der JFETs (J₁-J₆) jeweils einen vorgebbaren Strom zum ersten Anschluss (1) ableitet, insbesondere mittels in Sperrichtung betriebenen Schutzdioden (D₁₁-D₅₃) welche jeweils zwischen den Gateanschlüssen aufeinanderfolgender JFETS (J₁-J₆) oder zwischen den Gateanschlüssen der JFETs (J₁-J₆) und dem ersten Anschluss (1) angeordnet sind.

3. Schalteinrichtung gemäss Anspruch 1 oder 2, wobei die Zusatzschaltung (4) zusammen mit der Stabilisierungsschaltung (3) eine symmetrische Spannungsbelastung der Gateanschlüsse der JFETS (J₁-J₆) bewirkt.

4. Schalteinrichtung gemäss einem der bisherigen Ansprüche, wobei die Zusatzschaltung (4) eine oder mehrere in Serie und in Sperrichtung zwischen dem Gateanschluss (G₆) des obersten JFET (J₆) und dem zweiten Anschluss (2) betriebene weitere Dioden (D₆₁, D₆₂, D₆₃) aufweist.

5. Schalteinrichtung gemäss einem der bisherigen Ansprüche, wobei die Zusatzschaltung (4) ein passives Netwerk, insbesondere ein Widerstand ist, welches respektive welcher zwischen dem Gateanschluss (G₆) des obersten JFET (J₆) und dem zweiten Anschluss (2) angeschlossen ist.

6. Schalteinrichtung gemäss einem der bisherigen Ansprüche, wobei die Stabilisierungsschaltung (3) jeweils zwischen den Gateanschlüssen von aufeinanderfolgenden JFETs mindestens eine in Sperrichtung betriebene Diode mit einer ersten Gesamt-Sperrspannung aufweist, und die Zusatzschaltung (4) mindestens eine in Sperrichtung betriebene weiter Diode (D₆₁, D₆₂, D₆₃) mit einer zweiten Gesamt-Sperrspannung aufweist, wobei die zweite Gesamt-Sperrspannung mindestens annähend gleich der ersten Gesamt-Sperrspannung ist.

7. Schalteinrichtung gemäss Anspruch 1, wobei das Symmetriernetzwerk (5) jeweils zwischen den Gateanschlüssen von aufeinanderfolgenden JFETs (J₁-J₆) eine Kapazität (C_{Tu,1}-C_{Tu,5}) aufweist und parallel zur der Zusatzschaltung (4) eine weitere Kapazität (C_{Tu,6}) aufweist, und in Serie zu mindestens einer der Kapazitäten (C_{Tu,1}-C_{Tu,5}) und/oder der weiteren Kapazität (C_{Tu,6}) ein Dämpfungswiderstand (R_{St,1}-R_{St,5}, R_{St,6}) geschaltet ist

8. Schalteinrichtung gemäss Anspruch 1, wobei das Symmetriernetzwerk (5) jeweils zwischen den Gateanschlüssen von aufeinanderfolgenden JFETs (J₂-J₆) ausser dem untersten JFET (J₁) und dem ersten Anschluss (1) ein RC-Glied (R_{St,1}-R_{St,5} und C_{Tu,1}-C_{Tu,5}) aufweist, und parallel zur der Zusatzschaltung (4) ein Zusatz-RC-Glied (R_{St,6}, C_{Tu,6}) aufweist.

9. Schalteinrichtung gemäss Anspruch 8, wobei die Schaltung eine Ansteuerschaltung zum Ansteuern des Steuerschalters (M) aufweist, welche diesen in einem linearen Bereich betreibt.

## Claims

1. A switching device for switching a current between a first connection (1) and a second connection (2), comprising a series connection of at least two JFETs (J₁-J₆),
of which a lowermost JFET (J₁) is connected to the first connection (1) or the lowermost JFET (J₁) is connected in a cascode circuit via a control switch (M) to the first connection (1),
and at least one further JFET (J₂-J₆) which is connected in series to the lowermost JFET (J₁), wherein the JFET (J₆) which is distanced furthest from the lowermost JEFT (J₁) is indicated as the uppermost JFET (J₆) and with its drain connection is connected to the second connection (2), and
wherein a stabilisation circuit (D₁₁-D₅₃) for stabilising the gate voltages of the JEFTs (J₁-J₆) is connected between the gate connections of the JEFTs (J₁-J₆) and the first connection (1),
wherein an additional circuit (4) is connected between the gate connection (G₆) of the uppermost JFET (J₆) and the second connection (2), and this additional circuit draws the potential at the gate connection (G₆) of the uppermost JFET (J₆) to the potential at the drain connection (D₆) of the uppermost JFET (J₆)
**characterised in that** a symmetrising network (5) comprising an RC-network arranged between the gates of the JFETs (J₁-J₆) and the first connection is present, and
wherein the symmetrising network (5) is designed such that balancing processes in the symmetrising network (5) that occur when switching have the smallest time constant at the uppermost JFET (J₆) and the largest time constant at the lowermost JEFT (J₁).

2. The switching device according to claim 1, wherein the stabilisation circuit (3) in each case leads away a settable current from the gate connections of the JFETs (J₁-J₆) to the first connection (1), in particular by way of protective diodes (D₁₁-D₅₃) which are operated in the blocking direction (1) and which in each case are arranged between the gate connections of successive JFETs (J₁-J₆) or between the gate connections of the JFETs (J₁-J₆) and the first connection (1).

3. The switching device according to claim 1 or 2, wherein the additional circuit (4) together with the stabilisation circuit (3) effects a symmetrical voltage loading of the gate connections of the JEFTs (J₁-J₆).

4. The switching device according to one of the preceding claims, wherein the additional circuit (4) comprises one or more further diodes (D₆₁, D₆₂, D₆₃) which are operated in series and in the blocking direction between the gate connection (G₆) of the uppermost JFET (J₆) and the second connection (2).

5. The switching device according to one of the preceding claims, wherein the additional circuit (4) is a passive network, in particular a resistance, said network or resistance being connected between the gate connection (G₆) of the uppermost JEFT (J₆) and the second connection (2).

6. The switching device according to one of the preceding claims, wherein the stabilisation circuit (3) in each case between the gate connections of successive JFETS comprises at least one diode with a first total blocking voltage, said diode being operated in the blocking direction, and the additional circuit (4) comprises at least one further diode (D₆₁, D₆₂, D₆₃) with a second total blocking voltage, said further diode being operated in the blocking direction, wherein the second total blocking voltage at least approximately is equal to the first total blocking voltage.

7. The switching device according to claim 1, wherein the symmetrising network (5) in each case between the gate connections of successive JFETs (J₁-J₆) comprises a capacitance (C_{Tu,}1-C_{Tu,5}) and in parallel to the additional circuit (4) comprises a further capacitance (C_{Tu,6}), and a damping resistance (R_{St,1}-R_{St,5}, R_{St,6}) is connected in series to at least one of the capacitances (C_{Tu,1}- C_{Tu,5}) and/or to the further capacitance (C_{Tu,6}).

8. The switching device according to claim 1, wherein the symmetrising network (5) in each case between the gate connections of successive JFETs (J₂-J₆), apart from the lowermost JFET (J₁), and the first connection (1) comprises a RC-element (R_{St,1}-R_{St,5} and C_{Tu,1},- C_{Tu,5}), and comprises an additional RC-element (C_{Tu,6}R_{St,6}) parallel to the additional circuit (4).

9. The switching device according to claim 8, wherein the circuit comprises an activation circuit for activating the control switch (M) which operates this control switch in a linear range.

## Revendications

1. Circuit raccordant un courant entre une première borne de raccordement (1) et une deuxième borne de raccordement (2), le circuit présentant
un circuit série constitué d'au moins deux JFET (J₁-J₆) dont le JFET (J₁) le plus bas est raccordé à la première borne de raccordement (1) ou le JFET (J₁) le plus bas est raccordé à la première borne de raccordement (1) dans un circuit cascode par l'intermédiaire d'un commutateur de commande (M) et
au moins un deuxième JFET (J₂-J₆) raccordé en série au JFET (J₁) le plus bas, le JFET (J₆) le plus éloigné du JFET (J₁) le plus bas étant appelé JFET (J₆) le plus haut et étant raccordé par sa borne de drain à la deuxième borne de raccordement (2),
un circuit de stabilisation (D₁₁-D₅₃) qui stabilise les tensions de grille des JFET (J₁-J₆) étant raccordé entre les bornes de grille des JFET (J₁-J₆) et la première borne de raccordement (1),
un circuit supplémentaire (4) qui tire le potentiel de la borne de grille (G₆) du JFET (J₆) le plus haut vers le potentiel de la borne de drain (D₆) du JFET (J₆) le plus haut étant raccordé entre la borne de grille (G₆) du JFET (J6) le plus haut et la deuxième borne de raccordement (2),
**caractérisé en ce que**
un réseau de symétrisation (5) constitué d'un réseau RC est disposé entre les grilles des JFET (J₁-J₆) et la première borne de raccordement,
le réseau de symétrisation (5) étant conçu de telle sorte que lorsque des opérations d'équilibrage qui surviennent lors d'une opération de commutation présentent dans le réseau de symétrisation la constante de temps la plus petite sur le JFET (J₆) le plus haut et la constante de temps la plus grande sur le JFET (J₁) le plus bas.

2. Circuit selon la revendication 1, dans lequel le circuit de stabilisation (3) dérive un courant prédéterminé des bornes de grille des JFET (J₁-J₆) à la première borne de raccordement (1), en particulier au moyen de diodes de protection (D11-D₅₃) fonctionnant dans la direction de blocage et disposées entre les bornes de grille des JFET successifs (J1-J₆) ou entre les bornes de grille des JFET (J₁-J₆) et la première borne de raccordement (1).

3. Circuit selon les revendications 1 ou 2, dans lequel le circuit supplémentaire (4) a pour effet avec le circuit de stabilisation (3) une sollicitation symétrique de la tension sur les bornes de grille des JFET (J₁-J₆).

4. Circuit selon l'une des revendications précédentes, dans lequel le circuit supplémentaire (4) présente une ou plusieurs autres diodes (D₆₁, D₆₂, D₆₃) raccordées en série et fonctionnant dans la direction de blocage entre la borne de grille (G₆) du JFET (J₆) le plus haut et la deuxième borne de raccordement (2).

5. Circuit selon l'une des revendications précédentes, dans lequel le circuit supplémentaire (4) est un réseau passif, en particulier une résistance, raccordé entre la borne de grille (G₆) du JFET (J₆) le plus haut et la deuxième borne de raccordement (2).

6. Circuit selon l'une des revendications précédentes, dans lequel le circuit de stabilisation (3) présente entre les bornes de grille de chacun des JFET successifs au moins une diode fonctionnant dans la direction de blocage et présentant une première tension globale de blocage, le circuit supplémentaire (4) présentant au moins une autre diode (D₆₁, D₆₂, D₆₃) utilisée dans la direction de blocage à une deuxième tension globale de blocage, la deuxième tension globale de blocage étant au moins approximativement identique à la première tension globale de blocage.

7. Circuit selon la revendication 1, dans lequel le réseau de symétrisation (5) présente entre les bornes de grille de chacun des JFET successifs (J₁-J₆) une capacité (C_{Tu,1}-C_{Tu,5}) et une autre capacité (C_{Tu,6}) raccordée en parallèle au circuit supplémentaire (4), une résistance d'atténuation (R_{St,1}-R_{St,5}, R_{St,6}) étant raccordée en série à au moins l'une des capacités (C_{Tu,1}-C_{Tu,5}) et/ou à l'autre capacité (C_{Tu,6}).

8. Circuit selon l'une des revendications précédentes, dans lequel le réseau de symétrisation (5) présente entre les bornes de grille de chacun des JFET successifs (J₂-J₆), sauf le JFET (J₁) le plus bas, et la première borne de raccordement (1), un élément RC (R_{St,1}-R_{Sr,5} et C_{Tu,1}-C_{Tu,5}), ainsi qu'un élément RC supplémentaire (R_{St,6}, C_{Tu,6}) raccordé en parallèle au circuit supplémentaire (4).

9. Circuit selon la revendication 8, dans lequel le circuit présente un circuit de commande qui commande le commutateur de commande (M) qui fait fonctionner ce dernier en fonctionnement linéaire.
